# EUROPEAN PATENT APPLICATION

(11) **EP 4 768 998 A1**
(43) Date of publication of application: **01.07.2026**
(21) Application number: 25168939.4
(22) Date of filing: 07.04.2025
(51) Int. Cl.: G02B 6/44, H04Q 1/00

(54) **MODULAR OPTICAL SHUFFLE DEVICE FOR A FIBER OPTIC NETWORK AND METHOD OF USING SAME**

(30) Priority: 30.12.2024 US 202463739884 P
(71) Applicant: Corning Research & Development Corporation, Corning, New York 14831 (US)
(72) Inventor: CIECHOMSKI, Tomasz Andrzej, 91-728 Lodz (PL); JANASZ, Lukasz Piotr, 91-148 Lodz (PL)
(74) Representative: Reddie & Grose LLP

(57) **Abstract**

An optical shuffle device (78) for mounting in an equipment rack (80) of a fiber optic network. The shuffle device (78) includes a shuffle housing (82) defining a mounting region (92) and a plurality of shuffle modules (84) arranged in the mounting region. Each of the shuffle modules (84) is separate from the other shuffle modules (84) and is movable between a first position and a second position. The shuffle device (78) may include locking mechanisms (100) to secure the shuffle modules (84) in the first position, and optionally in the second position. The modularity of the shuffle device (78) and the ability to move the shuffle modules (84) between these positions allows installers to isolate each of the shuffle modules (84) one at a time and more easily connect fiber optic connectors to connector ports of the shuffle device. A method of using the optical shuffle device (78) is also disclosed.

## Description

### Priority Application

This application claims the benefit of priority of U.S. Provisional Application No. 63/739,884, filed on December 30, 2024, the content of which is relied upon and incorporated herein by reference in its entirety.

### Technical Field

This disclosure relates generally to fiber optic connectivity, and more particularly to an optical shuffle device for a fiber optic network having a modular configuration. The disclosure also relates to a method of using the modular optical shuffle device in a fiber optic network.

### Background

Optical fibers are useful in a wide variety of applications, including the information technology (IT) industry for transmitting data. Benefits of optical fibers include wide bandwidth and low noise operation. The large amount of data and other information transmitted over the internet has led businesses and other organizations to develop large scale data centers for organizing, processing, storing and/or disseminating large amounts of data. Data centers contain a wide range of network equipment including, for example, servers, networking switches, routers, storage subsystems, etc. Data centers further include a large amount of cabling and equipment racks to organize and interconnect the network equipment in the data center. Modern data centers may include multi-building campuses having, for example, one primary or main building and a number of auxiliary buildings in close proximity to the main building. All the buildings on the campus are interconnected by a local fiber optic network.

More recently, the emergence of artificial intelligence (AI) and machine learning applications has created a demand for data centers that provide large computer clusters of increasing size. These computer clusters are often implemented in hyperscale data centers that include hundreds or thousands of interconnected data processing units (e.g., graphics processing units (GPUs)) to provide the necessary computing power. The data processing units of the computer cluster are typically connected by a data network that provides high-speed/high-bandwidth communication between any two data processing units of the computer cluster.

By way of example, a typical computer cluster configured to support an AI system may include a plurality of scalable units (e.g., 32 scalable units) each including a plurality of servers (e.g., 32 servers), with each server including multiple data processing units (e.g., 8 GPUs). Thus, a typical computer cluster can easily include 8,192 or more data processing units. The data network that connects these data processing units may include two switching layers in a spine-leaf configuration. In this type of network, each data processing unit may be operatively coupled to a leaf switch by one or more optical fibers, and each leaf switch may be operatively coupled to one or more spine switches by additional optical fibers. A typical scalable unit configuration may include four servers being placed in each of eight server racks (32 servers total), and eight leaf switches placed in a single leaf switch rack. The equipment racks may be arranged in a row, with the leaf switch rack located in the middle of the row to minimize the mean distance between the leaf switches and the servers.

Each leaf switch in the above exemplary computer cluster may include a large number of connector ports, e.g., 64 connector ports. A portion of the leaf switch connector ports (e.g., 32 connector ports) may be operatively coupled to a like number of server connector ports each corresponding to a respective data processing unit. Another portion of the leaf switch connector ports (e.g., the other 32 connector ports) may be operatively coupled to a like number of switch connector ports corresponding to one or more spine switches. In a conventional data center, each data processing unit connector port may be connected to a respective leaf switch connector port in one of the leaf switches by a connectorized fiber optic cable. Thus, for the example mentioned above involving 32 servers each having eight data processing units (and, therefore, 8 x 32 data processing unit ports) and eight leaf switches each having 32 connector ports that may be operatively coupled to the data processing unit connector ports, cabling a single scalable unit may require an installer to install 256 fiber optic cables between the server racks and the leaf switch rack, and another 256 fiber optic cables between the leaf switch rack and one or more spine switch racks. A computer cluster including 32 scalable units would thus require the design and installation of at least 16,384 fiber optic cables, not including any fiber optic cables required to provide connections between spine switches or for redundancy.

The optical fibers associated with the server connector ports and the optical fibers associated with the switch connector ports may be connected according to predetermined fiber routing plan. Fiber routing plans are often complex. To aid in directing optical signals to their desired destinations according to complex fiber routing plans, equipment racks may include an optical shuffle device. An optical shuffle device generally includes an input optical interface having a plurality of input connector ports and an output optical interface having a plurality of output connector ports. A plurality of optical fibers extend between the connector ports on the input optical interface and the connector ports on the output optical interface and within a housing of the optical shuffle device. The optical fibers from each of the input connector ports may be distributed to one or more of the output connector ports according to the predetermined fiber routing plan. In other words, the complexities in the fiber routing plan may be carried out in the optical shuffle device as opposed to the physical connections of optical fibers carried by fiber optic cables that connect the two devices which are subject to the fiber routing plan.

While optical shuffle devices simplify the physical connection between devices in the fiber optic network, there remain some drawbacks to their use in network environments, such as hyperscale data centers. In this regard, current optical shuffle devices generally have a static construction where the input connector ports on the input optical interface and the output connector ports on the output optical interface are generally fixed within a generally planar panel in a side-by-side configuration. In other words, all of the input connector ports, for example, lie within the same plane. With fiber densities continually increasing, the spacing between adjacent connector ports on the optical interfaces continues to decrease, i.e., there are more connector ports per unit area of the optical interfaces. While this can have many advantages, so to can it have disadvantages. One disadvantage, for example, is that the large connector ports in a small space can make it difficult and time consuming for installers to make physical connections between fiber optic connectors of fiber optic cables and the input connector ports or the output connector ports on their respective optical interfaces of the optical shuffle device.

Manufacturers and installers continually strive to improve the interconnectivity of equipment within a fiber optic network. In the instant case, there is a need in the telecommunications industry to improve the ease of making optical connections with input connector ports and/or output connector ports of optical shuffle devices positionable within network equipment racks.

### Summary

In one aspect of the disclosure, an optical shuffle device for mounting in an equipment rack of a fiber optic network is disclosed. The optical shuffle device includes a shuffle housing configured to be mountable in the equipment rack and including a base, a first side wall, a second side wall, and a first guide rail extending between the first and second side walls. The base defines a mounting region of the shuffle housing. The first guide rail comprises a beam spaced above the base and a plurality of first retention tabs distributed along the beam and extending from the beam toward the base. The optical shuffle device further includes a plurality of shuffle modules configured to be arranged in the mounting region of the shuffle housing. Each of the plurality of shuffle modules is separate from the other plurality of shuffle modules and, when arranged in the mounting region of the shuffle housing, each shuffle module of the plurality of shuffle modules is movable (such as being slidable) in a longitudinal direction between an operative position and an installation position. The shuffle module is configured to selectively engage one of the first retention tabs to lock the shuffle module in the operative position or the installation position. The modular construction of the optical shuffle device and the movement of the shuffle modules between these two positions facilitates installation by allowing installers to isolate the connector ports on each of the plurality of shuffle modules one at a time.

In one embodiment, each of the plurality of shuffle modules may define a height Hₘ and the beam of the first guide rail may be spaced from the base by a distance generally corresponding to the height Hₘ of the plurality of shuffle modules. Furthermore, each of the plurality of shuffle modules may define a width Wₘ and the plurality of first retention tabs may be equally spaced along the beam of the first guide rail by a distance generally corresponding to the width Wₘ of the plurality of shuffle modules.

In one embodiment, the shuffle housing may further include a second guide rail extending between the first and second side walls of the shuffle housing and spaced from the first guide rail. The second guide rail may comprise a beam spaced above the base and a plurality of second retention tabs distributed along the beam and extending from the beam toward the base. In one embodiment, the plurality of first retention tabs on the first guide rail and the plurality of second retention tabs on the second guide rail may be generally aligned in the longitudinal direction to define a plurality of module bays, where each of the plurality of module bays is configured to receive a respective one of the plurality of shuffle modules.

In one embodiment, the optical shuffle device may include a plurality of guide pegs extending from the base of the shuffle housing. The plurality of guide pegs may be arranged in at least one row, and preferably at least two rows. across the base. Additionally, the plurality of first retention tabs on the first guide rail and the plurality of guide pegs may also be generally aligned in the longitudinal direction. Thus, the plurality of guide pegs may additionally help define the plurality of module bays and maintain separation of adjacent shuffle modules on the optical shuffle device.

The optical shuffle device is configured to be received in an equipment rack of the fiber optic network. To this end, the optical shuffle device may include a front pair of mounting brackets connected to the shuffle housing, such as at the first and second side walls, and a rear pair of mounting brackets slidably coupled to the shuffle housing. The front pair of mounting brackets and the rear pair of mounting brackets are configured to support the optical shuffle device within the equipment rack.

In one embodiment, each of the plurality of shuffle modules may include a module housing defining a first end, a second end, and an interior cavity. The module housing may further include a plurality of first connector ports at the first end of the module housing, at least one second connector port at the second end of the module housing, and a plurality of optical fibers extending within the interior cavity between the plurality of first connector ports and the at least one second connector port in a predetermined pattern. In one embodiment, the at least one second connector port may include a plurality of second connector ports. In one embodiment, the plurality of first connector ports and the at least one second connector port may each be configured in an (n x 1) array, where n is the number of first and second connector ports, respectively.

In one embodiment, the optical shuffle device may include a plurality of first locking mechanisms, where each of the plurality of first locking mechanisms is configured to lock a respective one of the plurality of shuffle modules in the installation position. In one embodiment, each of the plurality of first locking mechanisms may include a first locking arrangement associated with a respective shuffle module of the plurality of shuffle modules and a second locking arrangement associated with the shuffle housing. The first locking arrangement and the second locking arrangement are configured to cooperate in a manner that locks the respective shuffle module in the installation position.

In one embodiment, the first locking arrangement associated with each of the plurality of shuffle modules may include a biasing member moveable relative to the module housing between an extended position and a retracted position and a retention groove formed in the module housing opposite the biasing member. In one embodiment, the biasing member may include a projecting portion that extends a first distance outboard of the module housing when in the extended position, and the projecting portion either extends outboard of the module housing by less than the first distance or is inboard of the module housing when in the retracted position. For example, the biasing member may include a ball plunger. In this embodiment, the ball plunger may include a casing having an interior cavity, a spring disposed in the interior cavity, and a ball at least partially received in the interior cavity. The spring engages the ball to bias the ball toward the extended position. The ball, however, is moveable to the retracted position with compression of the spring.

In one embodiment, the second locking arrangement associated with the shuffle housing includes one of the plurality of first retention tabs of the first guide rail. Thus, the plurality of first retention tabs not only facilitates placement and organization of the plurality of shuffle modules on the mounting region of the shuffle housing, but also operates as part of the first locking mechanisms that retain the plurality of shuffle modules in the installation position.

In one embodiment, the shuffle housing may include a plurality of second locking mechanisms each configured to lock a respective shuffle module of the plurality of shuffle modules in the operative position. In one embodiment, the plurality of first locking mechanisms and the plurality of second locking mechanisms are different locking mechanisms and may be located at different positions in the optical shuffle device. In one embodiment, each of the plurality of second locking mechanisms may include a third locking arrangement associated with a respective shuffle module of the plurality of shuffle modules and a fourth locking arrangement associated with the shuffle housing. The third locking arrangement and the fourth locking arrangement are configured to cooperate in a manner that locks the respective shuffle module in the operative position.

In one embodiment, for each shuffle module of the plurality of shuffle modules the associated third locking arrangement may include a biasing member moveable relative to the module housing between an extended position and a retracted position and a retention groove formed in the module housing opposite the biasing member. In one embodiment, the biasing member of the third locking arrangement may include a projecting portion that extends a first distance outboard of the module housing when in the extended position, and the projecting portion either extends outboard of the module housing by less than the first distance or is inboard of the module housing when in the retracted position.

In one embodiment, the fourth locking arrangement associated with the shuffle housing may include one of the plurality of second retention tabs of the second guide rail. Thus, the plurality of second retention tabs not only facilitates placement and organization of the plurality of shuffle modules on the mounting region of the shuffle housing, but also operates as part of the second locking mechanisms that retain the plurality of shuffle modules in the operative position.

In one embodiment, the base of the shuffle housing may include an extension portion that provides sufficient space to allow each of the plurality of shuffle modules to move between their operative and installation positions. The extension portion also provides room for fiber optic cables that are connected to the input connector ports of the plurality of shuffle modules. In one embodiment, the extension portion may include a flap at its end that is moveable between an opened position and a closed position. The flap may be positioned in the opened position when the plurality of shuffle modules is being moved between their operative position and installation position during, for example, an installation procedure.

In a further aspect of the disclosure, an equipment rack of a fiber optic network includes at least one optical shuffle device according to the first aspect described above mounted therein. In one embodiment, the equipment rack may include a plurality of optical shuffle devices mounted therein.

In yet another aspect of the disclosure, a method of using an optical shuffle device in a fiber optic network is disclosed. The optical shuffle device includes a shuffle housing configured to be mountable in the equipment rack of the fiber optic network and a plurality of shuffle modules arranged in a mounting region of the shuffle housing. Each of the shuffle modules includes a plurality of first connector ports at the first end, a plurality of second connector ports at the second end, and a plurality of optical fibers extending within the interior cavity between the plurality of first connector ports and the plurality of second connector ports in a predetermined pattern. The method includes: i) moving one of the plurality of shuffle modules from an operative position to an installation position; ii) connecting at least one fiber optic connector to a respective one of the plurality of first connector ports of the one of the plurality of shuffle modules while in the installation position; and iii) moving the one of the plurality of shuffle modules from the installation position to the operative position. In one embodiment, the method may further include repeating steps i)-iii) for at least some and possibly all of the remaining plurality of shuffle modules in the shuffle housing.

In one embodiment, the method may further include disengaging a first locking mechanism that locks the one of the plurality of shuffle modules in the operative position. In one embodiment, disengaging the first locking mechanism may include overcoming a biasing of a first retention groove associated with the one of the plurality of shuffle modules into engagement with one of a plurality of first retention tabs associated with the shuffle housing. For example, moving the one of the plurality of shuffle modules from the operative position to the installation position may include applying a first force on the one of the plurality of shuffle modules to disengage the first locking mechanism that locks the one of the plurality of shuffle modules in the operative position and applying a second force on the one of the plurality of shuffle modules to move the shuffle module to the installation position. In one embodiment, applying the first force may include applying the first force in a first direction, applying the second force may include applying the second force in a second direction, and the first direction and the second direction may be different from each other, such as being perpendicular to each other. In one embodiment, the first direction may be different from an insertion direction of the at least one fiber optic connector when connecting the at least one fiber optic connector to the respective one of the plurality of first connector ports of the one of the plurality of shuffle modules.

In one embodiment, the method may further include engaging a second locking mechanism to lock the one of the plurality of shuffle modules in the installation position. In one embodiment, engaging the second locking mechanism may include biasing a second retention groove associated with the one of the plurality of shuffle modules into engagement with one of a plurality of second retention tabs associated with the shuffle housing. For example, moving the one of the plurality of shuffle modules from the installation position to the operative position may include applying a third force on the one of the plurality of shuffle modules to disengage the second locking mechanism that locks the one of the plurality of shuffle modules in the installation position and applying a fourth force on the one of the plurality of shuffle modules to slidably move the one of the plurality of shuffle modules to the operative position. In one embodiment, applying the third force may include applying the third force in a third direction, applying the fourth force may include applying the fourth force in a fourth direction, and the third direction and the fourth direction may be different from each other, such as being perpendicular to each other. In one embodiment, the third direction may be different from an insertion direction of the at least one fiber optic connector when connecting the at least one fiber optic connector to the respective one of the plurality of first connector ports of the one of the plurality of shuffle modules. In one embodiment, the third force is sufficient to overcome the biasing of the second retention groove associated with the one of the plurality of shuffle modules into engagement with one of a plurality of second retention tabs associated with the shuffle housing.

In yet another aspect of the disclosure, an optical shuffle device for mounting in an equipment rack of a fiber optic network is disclosed. The optical shuffle device comprises a shuffle housing configured to be mountable in the equipment rack. The shuffle housing includes a base, a first side wall, a second side wall, and a first guide rail extending between the first and second side walls. The base defines mounting region of the shuffle housing. The first guide rail comprises a beam spaced above the base and a plurality of retention tabs distributed along the beam and extending from the beam toward the base. The optical shuffle device also includes a plurality of shuffle modules configured to be arranged in the mounting region of the shuffle housing. Each shuffle module comprises: a module housing defining opposed first and second ends, opposed top and bottom walls, opposed first and second side walls, and an interior cavity; a plurality of first connector ports at the first end of the module housing; a first biasing member on the first side wall, wherein the first biasing member is moveable relative to the first side wall between an extended position and a retracted position; and a first retention groove on the second side wall at a location opposite the first biasing member. When arranged in the mounting region of the shuffle housing, each shuffle module of the plurality of shuffle modules is movable in a longitudinal direction between a first position and a second position. Additionally, when each shuffle module of the plurality of shuffle modules is in the first position, the first biasing member on the first side wall is configured to cooperate with one of the retention tabs to position the shuffle module to cause another of the retention tabs to be received in the first retention groove on the second side wall and thereby interfere with the shuffle module moving in the longitudinal direction. The shuffle module can be repositioned with the first biasing member moving to its retracted position, which results in the another of the retention tabs to no longer be positioned in the first retention groove and thereby allow movement in the longitudinal direction (e.g., to the second position).

In yet another aspect of the disclosure, a shuffle module is provided, wherein the shuffle module comprises: a module housing defining opposed first and second ends, opposed top and bottom walls, opposed first and second side walls, and an interior cavity; a plurality of first connector ports at the first end of the module housing; a first biasing member on the first side wall, wherein the first biasing member is moveable relative to the first side wall between an extended position and a retracted position; and a first retention groove on the second side wall at a location opposite the first biasing member.

Additional features and advantages will be set forth in the detailed description which follows, and in part will be readily apparent to those skilled in the technical field of optical connectivity. It is to be understood that the foregoing general description, the following detailed description, and the accompanying drawings are merely exemplary and intended to provide an overview or framework to understand the nature and character of the claims.

### Brief Description of the Drawings

The accompanying drawings are included to provide a further understanding and are incorporated in and constitute a part of this specification. The drawings illustrate one or more embodiment(s), and together with the description serve to explain principles and operation of the various embodiments. Features and attributes associated with any of the embodiments shown or described may be applied to other embodiments shown, described, or appreciated based on this disclosure.
Fig. 1 is a schematic illustration of a data center campus.
Figs. 2 and 3 are partial perspective views of an exemplary data hall of the data center shown in Fig. 1.
Fig. 4 is a diagrammatic view of exemplary equipment racks, including a plurality of server racks and a switch rack.
Fig. 5 is a diagrammatic view of a server rack and the switch rack of Fig. 4 depicting connection between : i) a server-side optical shuffle device and servers in the server rack; ii) a switch-side optical shuffle device and switches in the switch rack; and iii) the server side and switch-side optical shuffle devices.
Fig. 6 is a partial perspective view of an optical shuffle device according to an embodiment of the disclosure mounted in an equipment rack.
Fig. 7 is a perspective view of the optical shuffle device illustrated in Fig. 6 with the shuffle modules in their operative position.
Fig. 8 is a perspective view of a shuffle housing for the optical shuffle device illustrated in Figs. 6 and 7.
Fig. 9 is a perspective view of a shuffle module according to an embodiment of the disclosure mountable in the shuffle housing shown in Fig. 8.
Fig. 10 is a cross-sectional view through the shuffle module shown in Fig. 9 illustrating a biasing member according to an embodiment of the disclosure.
Fig. 11 is a top plan view of the optical shuffle device illustrating one of the shuffle modules in its installation position.
Fig. 12 is a partial cross-sectional view through the optical shuffle device illustrated in Fig. 11.
Fig. 13 is a partial cross-sectional view through the optical shuffle device illustrating a rear locking mechanism for locking the shuffle module in the operative position.
Fig. 14 is a partial cross-sectional view through the optical shuffle device illustrating the front locking mechanism as the shuffle module nears the installation position.
Fig. 15 is a partial cross-sectional view through the optical shuffle device illustrating the front locking mechanism in the installation position.
Fig. 16 is a partial cross-sectional view through the optical shuffle device illustrating the rear locking mechanism as the shuffle module nears the installation position.

### Detailed Description

Various embodiments will be further clarified by examples in the description below. In general, the description relates to a modular optical shuffle device having a plurality of shuffle modules arranged in a side-by-side manner in the shuffle device. Each of the shuffle modules is slidably moveable in a longitudinal direction between two different positions (i.e., a first position and a second position). One of the positions may be regarded as an operative position and the other position may be regarded as an installation position. For each shuffle module, fiber optic connectors from fiber optic cables are configured to be connected to the shuffle module when the shuffle module is in its installation position. The optical shuffle device is configured to be in use when the shuffle modules are in their operative position. Thus, by moving a selected shuffle module to the installation position while the remaining shuffle modules remain in their operative position, the connector ports of the selected shuffle module may be isolated or separated from the connector ports of the remaining shuffle modules. Thus, installers may insert the fiber optic connectors from the fiber optic cables into respective connector ports on the selected shuffle module without the congestion and interference associated with the connector ports and cables associated with the other shuffle modules. The ability to isolate the connector ports of just one of the plurality of shuffle modules greatly eases installation of the fiber optic connectors for those connector ports.

Advantageously, each of the shuffle modules may be locked in either or both of its two positions (i.e., either or both of its installation position and operative position). Thus, the optical shuffle device may include a plurality of locking mechanisms that are each configured to lock a respective one of the shuffle modules in its installation position. The optical shuffle device may alternatively or additionally include a plurality of locking mechanisms to lock a respective one of the shuffle modules in its operative position. For each of the shuffle modules, each associated locking mechanism may include a respective biasing member on a first side wall of the shuffle module, a respective retention groove on a second side wall of the shuffle module at a location opposite the biasing member, and a respective retention tab associated with a housing of the optical shuffle device. The biasing member biases the retention groove into engagement with the associated retention tab to inhibit movement of the shuffle module in the longitudinal direction. To disengage the locking mechanism, an installer applies a first force on the shuffle module in a first direction to overcome the bias of the biasing member and thereby position the shuffle module so that the associated retaining tab disengages from the retention groove. The installer may then apply a second force on the shuffle module in the longitudinal direction to slidably move the shuffle module. The first direction of the installer's first force and the longitudinal direction in which the shuffle module is configured to slide may be generally different from each other and preferably perpendicular to each other. These and other aspects of the optical shuffle device will be described in further detail below.

First, however, note that the term "shuffle" is used in this disclosure in a general sense to refer to a change in arrangement of optical fibers from one end of a device (e.g., a shuffle module) to another end of the device. The two ends of the device may have a similar connection interface (e.g., same number and type of connector ports), with the positions of optical fibers within the two connection interfaces being different. Alternatively, the ends of the device may have different connection interfaces, and optical fibers may transition between the two connection interfaces with or without changing relative positions. For example, a "transition" or "breakout" module (e.g., having duplex connector ports on one end and one or more multifiber connector ports on another end) is considered to be a shuffle module for purposes of this disclosure.

Also note that this disclosure refers to height (Hₘ) and width (Wₘ) dimensions in relation to certain elements. When two dimensions are described as "generally corresponding", this refers to one dimension being the same or only slightly larger than the other dimension, such as being less than 15% larger.

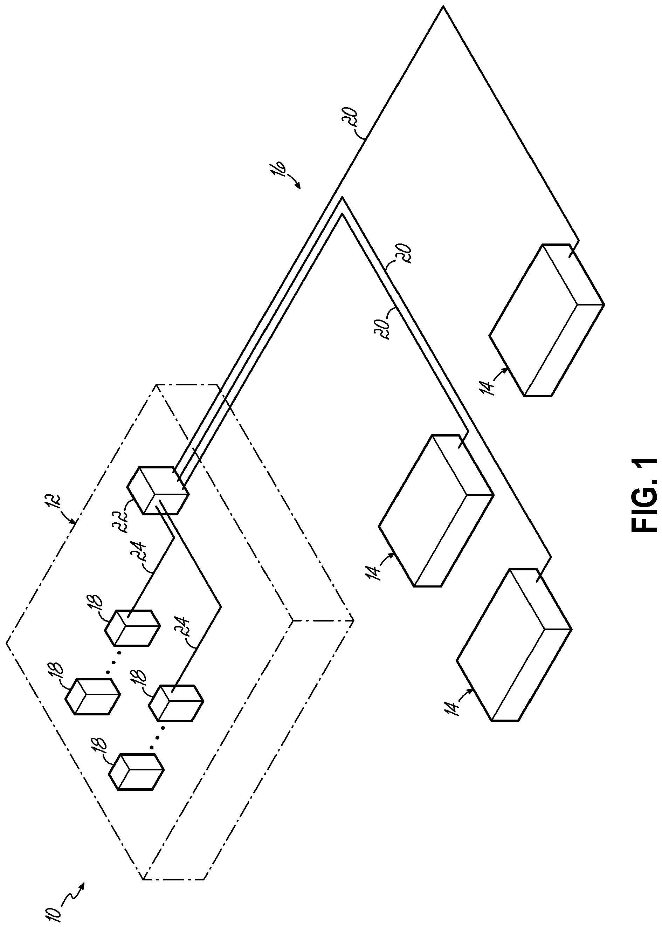

As illustrated in Fig. 1, a modern-day data center 10 may include a collection of buildings (referred to as a data center campus) having, for example, a main building 12 and one or more auxiliary buildings 14 in close proximity to the main building 12. While three auxiliary buildings are shown, there may be more or less depending on the size of the campus. The data center 10 provides for a local fiber optic network 16 that interconnects the auxiliary buildings 14 with the main building 12. The local fiber optic network 16 allows network equipment 18 in the main building 12 to communicate with various network equipment (not shown) in the auxiliary buildings 14. In the exemplary embodiment shown, the local fiber optic network 16 includes trunk cables 20 extending between the main building 12 and each of the auxiliary buildings 14. Conventional trunk cables 20 generally include a high fiber-count arrangement of optical fibers for passing data and other information through the local fiber optic network 16. In the example illustrated in Fig. 1, the trunk cables 20 from the auxiliary buildings 14 are routed to one or more distribution cabinets 22 housed in the main building 12 (one shown).

Within the main building 12, a plurality of indoor fiber optic cables 24 ("indoor cables 24") are routed between the network equipment 18 and the one or more distribution cabinets 22. The indoor cables 24 generally include a high fiber-count arrangement of optical fibers for passing data and other information from the distribution cabinets 22 to the network equipment 18. Although only the interior of the main building 12 is schematically shown in Fig. 1 and discussed above, each of the auxiliary buildings 14 may house similar equipment for similar purposes. Thus, although not shown, each of the trunk cables 20 may be routed to one or more distribution cabinets 22 in one of the auxiliary buildings 14 in a manner similar to that described above. Furthermore, each of the auxiliary buildings 14 may include indoor cables 24 that extend between network equipment 18 and the one or more distribution cabinets 22 of the auxiliary building 14.

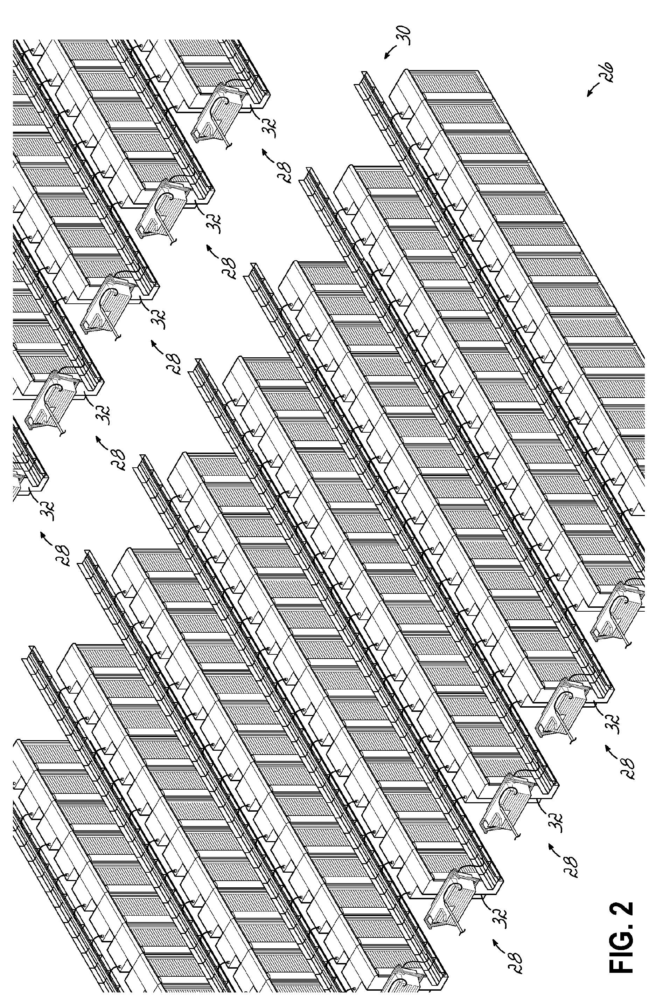

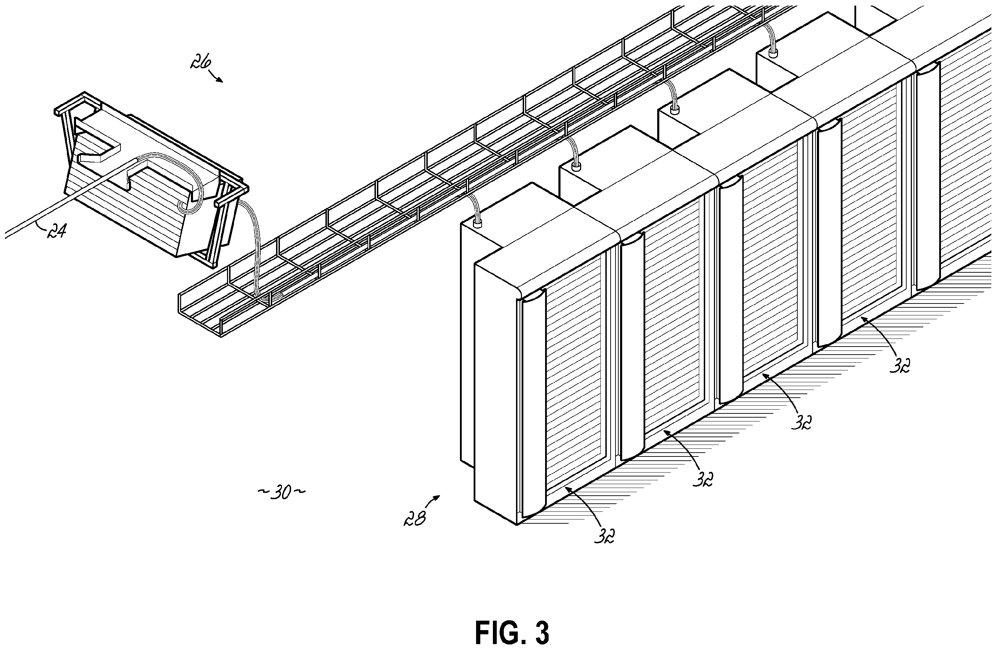

As illustrated in more detail in Figs. 2 and 3, the network equipment 18 in the main building 12 or an auxiliary building 14 may be arranged in one or more data halls 26 that generally include a plurality of spaced-apart rows 28 on one or both sides of an access pathway 30. The arrangement of the data halls 26 into rows 28 helps organize the large number of equipment, fiber optic cables, fiber optic connections, etc. Each of the rows 28 includes a plurality of equipment racks or cabinets 32 (referred to hereafter as "equipment racks 32" or "racks 32") generally arranged one next to the other along the row 28. Each of the equipment racks 32 is a vertically arranged framework for holding various network equipment 18 of the data center 10, as is generally known in the telecommunications industry.

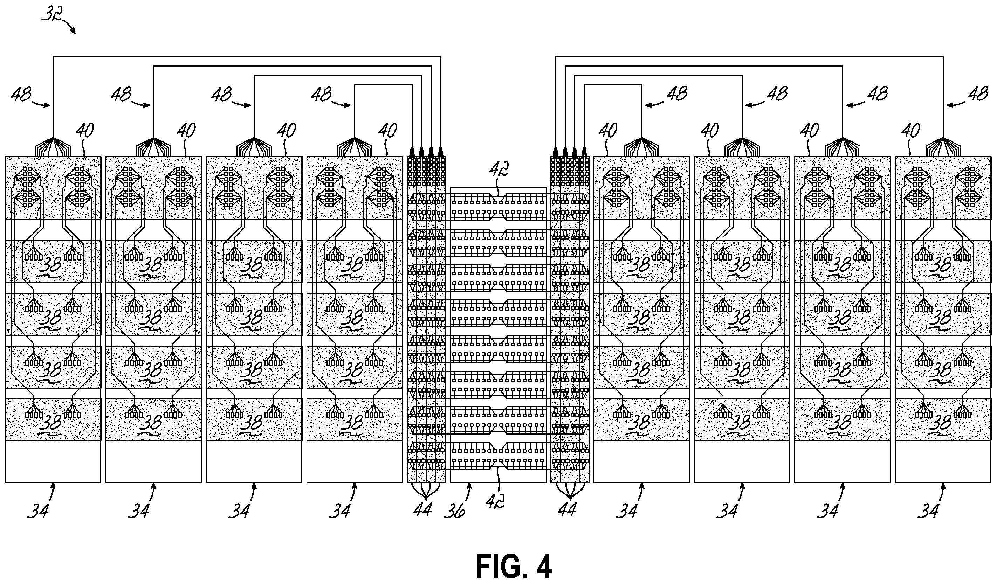

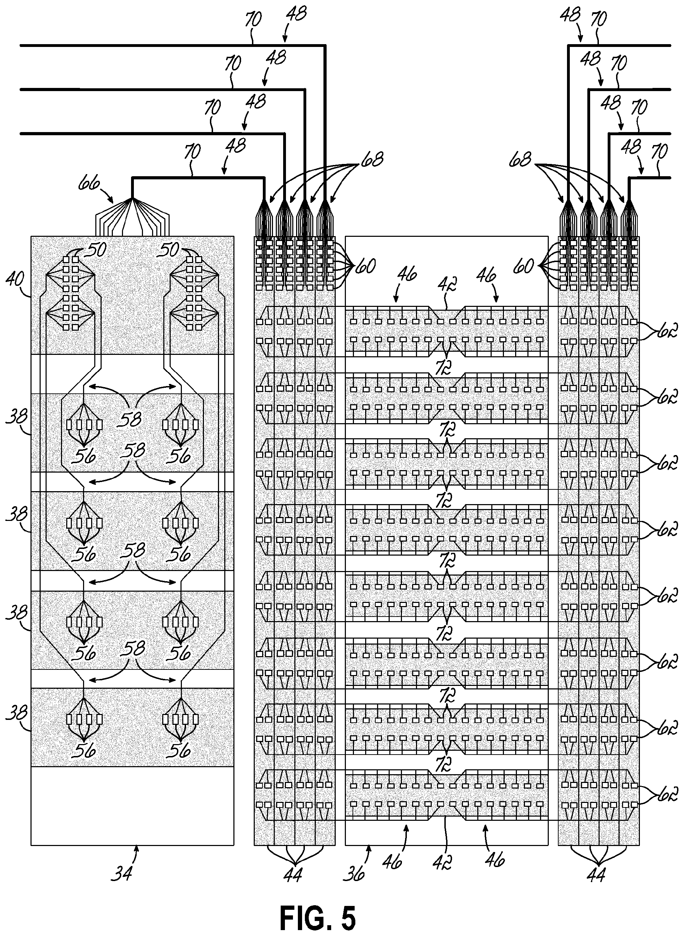

Figs. 4 and 5 depict exemplary equipment racks 32 in a row 28 of the data center 10, including a plurality of server racks 34 and a switch rack 36. Each server rack 34 includes a plurality of servers 38 that are operatively coupled to a server-side optical shuffle device 40. The switch rack 36 includes a plurality of switches 42 (e.g., leaf switches) each operatively coupled to one or more switch-side optical shuffle devices 44 by fiber optic cables 46. Each server-side optical shuffle device 40 is operatively coupled to a respective switch-side optical shuffle device 44, e.g., by another fiber optic cable 48. As best shown by Fig. 5, each server-side optical shuffle device 40 may include a plurality of input connector ports 50 (e.g., sixty-four connector ports) at a front optical interface of the server-side optical shuffle device 40. Each connector port 50 may be operatively connected to a plurality of optical fibers (e.g., 24 optical fibers). The optical fibers of the optical shuffle device extend within the optical shuffle device 40 and are operatively coupled to one of a plurality of out connector ports 54 (e.g., sixty-four connector ports) at a rear optical interface of the server-side optical shuffle device 40.

Each of the servers 38 includes a plurality of the server connector ports 56 (e.g., eight server connector ports 56). For each server connector port 56, an optical link is established between the server connector port 56 and one of the connector ports 50 of the server-side optical shuffle device 40. Fig. 5, for example, illustrates fiber optic cables 58 extending from the connector ports 50 on the server-side optical shuffle device 40 and coupling to respective groups of the server connector ports 56 of the servers 38. In the embodiment shown, each fiber optic cable 58 may include a trunk segment and a plurality of legs extending from an end thereof. The trunk segment may be terminated by a multi-fiber fiber optic connector, such as a multi-fiber push-on/pull-off (MPO) connector (e.g., according to IEC 61754-7) or MMC connector (available from US Conec, Ltd.), or small form factor (SFF) connectors in simplex or duplex configuration, such as LC connectors (e.g., according to IEC 61754-20). However, it should be understood that any suitable connector may be used, as will be appreciated by persons skilled in optical connectivity. The fiber optic connector of the trunk segment is configured to be received in a respective one of the plurality of connector ports 50 of the server-side optical shuffle device 40. In a similar manner, the other end of the trunk segment may include a plurality of legs and each leg may include a fiber optic connector configured to be connected to a respective server port 56 of a respective server 38 of server rack 34.

Each switch-side optical shuffle device 44 may include a plurality of connector ports 60 (e.g., 12 connector ports 60) and a plurality of connector ports 62 (e.g., 32 connector ports 62). Each switch-side optical shuffle device 44 may be configured to operatively couple optical fibers received by each of the associated switch-side connector ports 60 to optical fibers of the fiber optic cable 46 that couples to the connector ports 62. Each switch-side optical shuffle device 44 may therefore be configured to route optical signals between the optical fibers of one or more fiber optic cables 48 and the optical fibers of the fiber optic cables 46 in a predetermined manner or shuffle pattern.

Each fiber optic cable 48 may include a server-side breakout portion 66, a switch-side breakout portion 68, and a trunk segment 70 connecting the server-side breakout portion 66 and switch-side breakout portion 68. Each breakout portion of fiber optic cable 48 may include a plurality of legs. Each leg of the server-side breakout portion 66 may be terminated by a fiber optic connector (not shown) configured to be received in and couple to a connector port 54 of server-side optical shuffle device 40. Each leg of switch-side breakout portion 68 of fiber optic cable may be terminated by a fiber optic connector (not shown) configured to be received in and couple to an output connector port 60 of switch-side optical shuffle device 44. The connector ports 62 of the switch-side optical shuffle devices 44 may be operatively coupled to switch connector ports 72 of switches 42 in a predetermined manner by the plurality of fiber optic cables 46. In operation, the server-side optical shuffle devices 40, switch-side optical shuffle devices 44, and fiber optic cables 46, 48, 58 may collectively define optical connectivity between each server 38 and each switch 42.

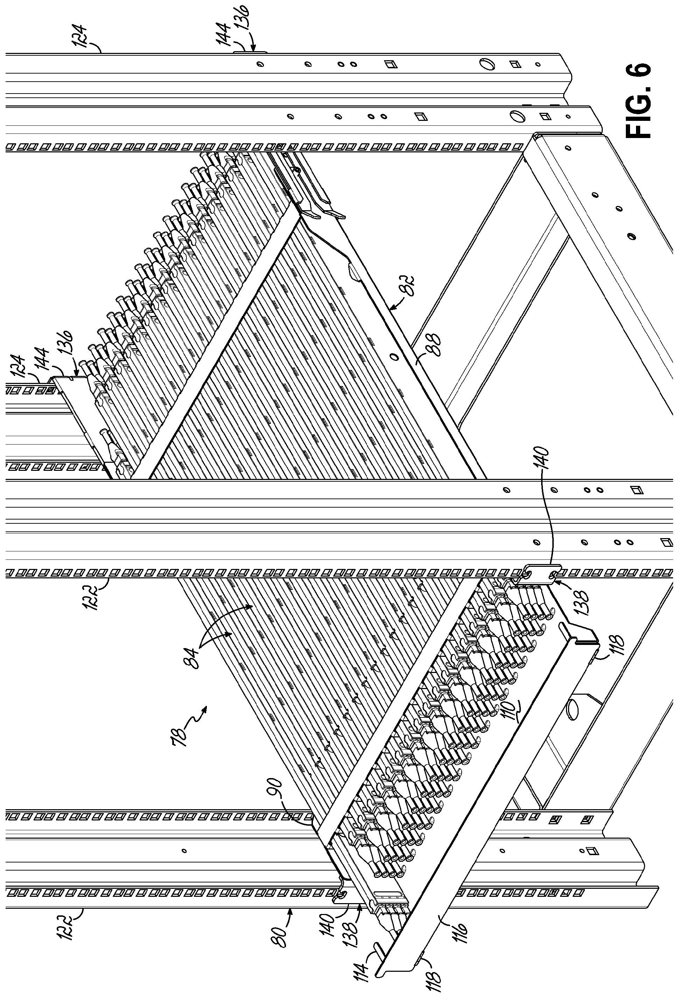

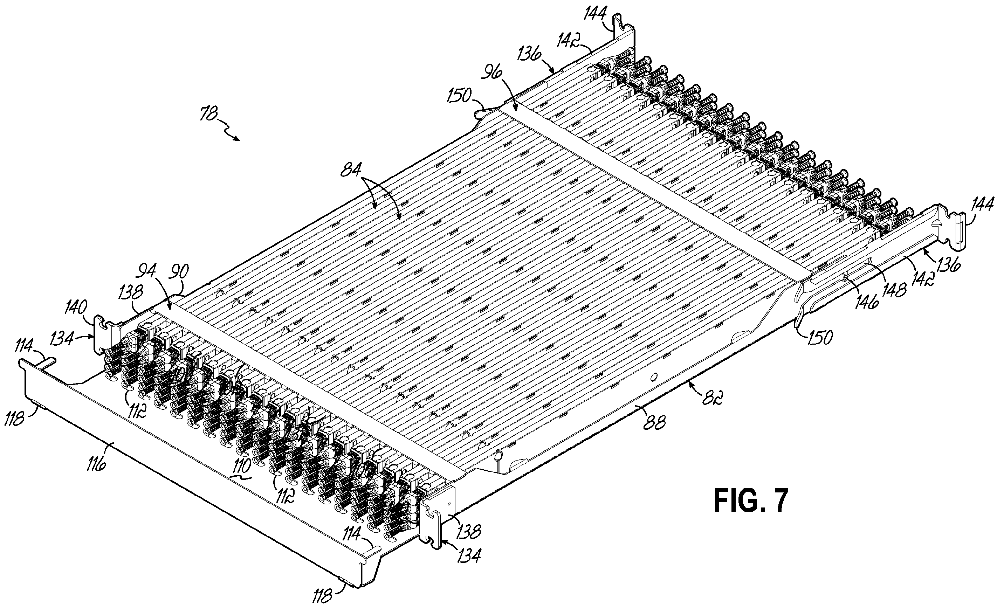

As noted above, because the connector ports on conventional optical shuffle devices are spatially fixed and generally lie within a common plane, it can be difficult for installers to insert fiber optic connectors, such as from the fiber optic cables from the connector ports of the servers, during installation. Figs. 6 and 7 illustrate an optical shuffle device 78 (referred to hereafter as "optical shuffle box 78" or just "shuffle box 78") in accordance with an embodiment of the disclosure that alleviates the difficulties typically experienced by installers during installation, as will now be described.

As illustrated in Fig. 6, the shuffle box 78 may be configured to be mounted within an equipment rack 80, which may be an equipment rack 32 within a row 28 of a data center 10, as illustrated in Figs. 2 and 3. Aspects of the shuffle box 78, however, are not limited to a data center environment and may be used in equipment racks in other portions of the fiber optic network. In one embodiment, the shuffle box 78 may include a shuffle box housing 82 that is configured to hold or carry a plurality of shuffle modules 84 arranged on or in the shuffle box housing 82 in a generally side-by-side arrangement across, for example, a width direction of the shuffle box housing 82. The plurality of shuffle modules 84 may be separate from each other. More importantly, however, each of the plurality of shuffle modules 84 may be independently movable relative to the shuffle box housing 82 between two primary positions, referred to herein as an installation position and an operative position. In other words, each of the shuffle modules 84 may be moved relative to the shuffle box housing 82 without needing to move any of the other shuffle modules 84. Any given one of the shuffle modules 84 may be arranged in its installation position while the remainder of the shuffle modules 84, including the shuffle modules 84 immediately adjacent the selected shuffle module 84, may be arranged in their operative position. The ability to effectively isolate each of the plurality of shuffle modules 84 provides a significant advantage during the installation process, as will be described below in more detail.

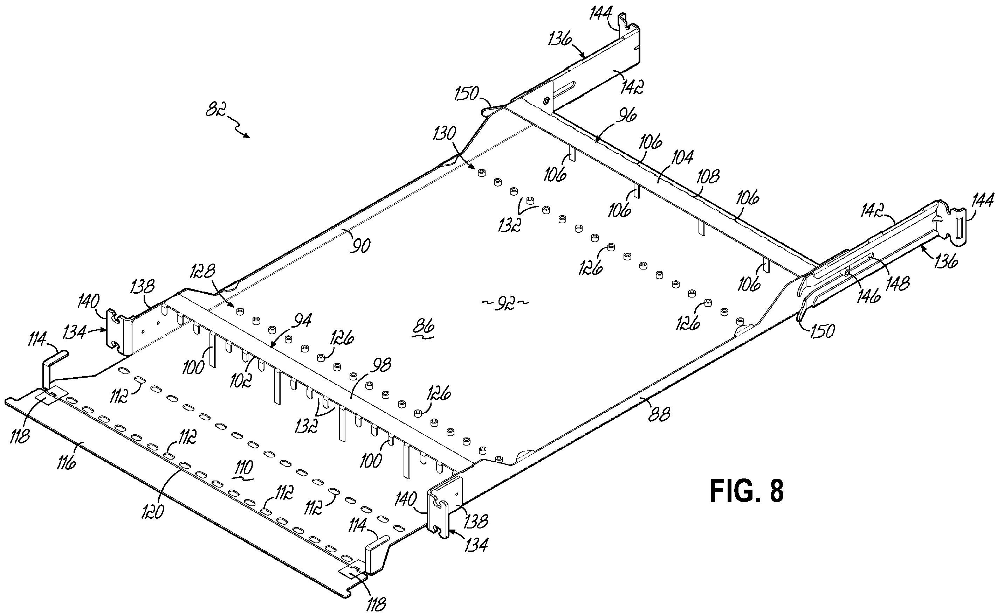

As best illustrated in Fig. 8, in one embodiment, the shuffle box housing 82 may include a base 86, a first side wall 88 extending upwardly from the base 86 at one side edge of the base 86, and a second side wall 90 extending upwardly from the base at an opposed side edge of the base 84. The base 86 generally defines a mounting region 92 between the first and second side walls 88, 90 configured to receive the plurality of shuffle modules 84. The shuffle box housing 82 may further include a front guide rail 94 extending between the first and second side walls 88, 90 in a front region of the base 86 and a rear guide rail 96 extending between the first and second side walls 88, 90 rear region of the base 86. In one embodiment, the front guide rail 94 may include a generally planar beam 98 extending from an upper edge of the first and second side walls 88, 90 that is vertically spaced from the base 86 by a distance that generally corresponds to a height Hₘ of the shuffle modules 84. The front guide rail 94 may further include a plurality of retention tabs 100 depending from the beam 98, such as at a front edge 102 thereof. The retention tabs 100 may be horizontally spaced from each other along the beam 98 by a distance that generally corresponds to a width Wₘ of the shuffle modules 84.

In the embodiment shown, a first subset of the plurality of retention tabs 100 do not extend all the way to the base 86 but only extend for a portion of the distance between the front guide rail 94 and the base 86. For example, the first subset of the plurality of retention tabs 100 may extend downwardly between about 5% and 30%, and preferably between about 10% and 20% of the distance between the front guide rail 94 and the base 86. A second subset of the plurality of retention tabs 100 extends downwardly so as to engage with or nearly engage with the base 86. The second subset of retention tabs 100 help to support the first guide rail 94 above the base 86 without significant deflections (e.g., sagging). By way of example, and without limitation, every fourth retention tab 100 may be configured to extend the full distance or nearly the full distance between the front guide rail 94 and the base 86. In alternative embodiments, a different number of the retention tabs 100, and possibly all of the retention tabs 100, may extend downwardly from the beam 98 to engage with or nearly engage with the base 86.

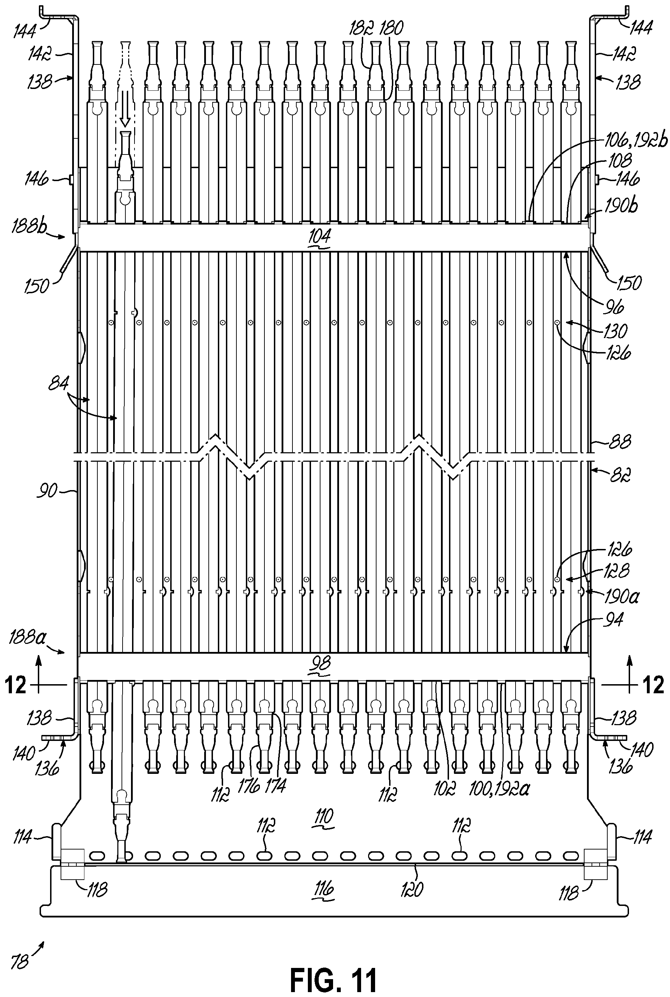

Similar considerations may apply to the rear guide rail 96. To this end, in the embodiment shown, the rear guide rail 96 may include a generally planar beam 104 extending from an upper edge of the first and second side walls 88, 90 that is vertically spaced from the base 86 by the distance that generally corresponds to the height Hₘ of the shuffle modules 84. The rear guide rail 96 may further include a plurality of retention tabs 106 depending from the beam 104, such as at a rear edge 108 thereof. Only some of the retention tabs 106 can be seen in Fig. 8 for reasons that will become apparent, but reference can be made to Fig. 11 to better view all of the retention tabs 106. The plurality of retention tabs 106 are spaced from each other along the beam 104 by the distance that generally corresponds to the width Wₘ of the shuffle modules 84.

In the embodiment shown, a first subset of the plurality of retention tabs 106 do not extend all the way to the base 86 but only extend for a portion of the distance between the rear guide rail 96 and the base 86. For example, the first subset of the plurality of retention tabs 106 may extend downwardly between about 5% and 30%, and preferably between about 10% and 20% of the distance between the rear guide rail 96 and the base 86. These are the retention tabs 106 that cannot be seen in Fig. 8 due to the orientation of the rear guide rail 96 in the illustration. A second subset of the plurality of retention tabs 106, which can be seen in Fig. 8, extends downwardly so as to engage with or nearly engage with the base 86. The second subset of the plurality of retention tabs 106 help to support the rear guide rail 96 above the base 86 without significant deflections. By way of example, and without limitation, every fourth tab 100 may be configured to extend the full distance or nearly the full distance between the rear guide rail 96 and the base 86.

As can be appreciated, the arrangement of the retention tabs 106 in the embodiment shown is the same as the arrangement of the retention tabs 100. In alternative embodiments, however, the retention tabs 100, 106 may have different arrangements in terms of the extent to which the tabs 100, 106 extend downwardly from the front guide rail 94 or rear guide rail 96.

As shown in Fig. 8, the base 86 of the shuffle box housing 82 may include an extension portion 110 adjacent a front of the shuffle box housing 82 that provides additional spacing for receiving fiber optic cables (not shown) that are connected to the input connector ports of the plurality of shuffle modules 84, as discussed below. In this regard, the extension portion 110 may include one or more cable guide elements that facilitate organizing and securing the fiber optic cables connected to the input connector ports of the plurality of shuffle modules 84. For example, the extension portion 110 may include a plurality of apertures 112 for receiving various tie downs. In one embodiment, for example, the apertures 112 may be provided in two or three rows (two shown) across a width of the shuffle box housing 82. The extension portion 110 may further include two or more L-shaped cable brackets 114 across the width of the shuffle box housing 82. In one embodiment, a cable bracket 114 may be positioned adjacent opposed side edges of the extension portion 110. It should be appreciated that other arrangements of the apertures 112 and brackets 114 are possible.

Furthermore, the shuffle box housing 82 may include a door or flap 116 rotatably mounted, such as being mounted by one or more hinges 118, to a front edge 120 of the extension portion 110. The flap 116 is moveable between an opened position (see Fig. 8) and a closed position (Fig. 6). During installation, for example, the flap 116 may be configured to be in the opened position to facilitate the connection of fiber optic connectors to the inlet connector ports of the plurality of shuffle modules 84 arranged in the shuffle box housing 82. However, when the fiber optic connectors have been connected to their respective input connector ports, the flap 116 may be moved to the closed position to help contain and control the fiber optic cables.

Moreover, the shuffle box housing 82 may include a plurality of guide pegs 126 extending upwardly from the base 86 to help retain the plurality of shuffle modules 84 in an aligned configuration in the mounting region 92 of the shuffle box housing 82. In one embodiment, for example, the plurality of guide pegs 126 may be configured in at least two rows of pegs 126 each being spaced apart in a width direction of the shuffle box housing 82. A first row of guide pegs 128 may be arranged closer to (e.g., near or adjacent) the front guide rail 94 and a second row of guide pegs 130 may be arranged closer to (e.g., near or adjacent) the rear guide gar 96. The plurality of guide pegs 126 in each of the first and second rows 128, 130 may be generally longitudinally aligned with respective retention tabs 100, 106 on the front guide rail 94 and the rear guide rail 96, respectively, as shown in Fig. 8. Thus, each of the pegs 126 in the front row 128 and the rear row 130 may be spaced from other pegs 126 in the same row (front row 128 or rear row 130) by the distance that generally corresponds to the width Wₘ of the shuffle modules 84. Collectively, the retention tabs 100 on the front rail 94, the guide pegs 126 in the front row 128 of pegs, the retention tabs 106 on the rear rail 96, and the guide pegs 126 on the rear row 130 of pegs define a plurality of module bays 132 in the mounting region 92 of the shuffle box 78 that is each configured to receive a respective one of the plurality of shuffle modules 84. While two rows of guide pegs 126 are shown, it should be appreciated that there may be more than two rows of guide pegs 126 in other embodiments. Additionally, it should be appreciated that the plurality of guide pegs 126 may be arranged in different configurations, such as also being distributed in the longitudinal direction (e.g., a zig-zag pattern) and remain within the scope of the disclosure.

In one embodiment, the shuffle box housing 82 may be substantially made from metal, such as a suitable gauge aluminum sheet metal. In alternate embodiments, however, the shuffle box housing 82 may be formed from other materials, such as suitable plastic materials.

As shown in Figs. 6-8, the shuffle box 78 may be mounted to the front support beams 122 and rear support beams 124 of the equipment rack 80 by a pair of front mounting brackets 134 and a pair of rear brackets 136, respectively. In one embodiment, each of the front mounting brackets 134 may be generally L-shaped with a first flange 138 attachable to the outer surface of the side walls 88, 90 with a suitable fastener, such as a screw, bolt, clip, etc., and a second flange 140 extending outwardly from the respective side wall 88, 90 attachable to the front support beams 122. In this regard, the second flange 140 may include one or more openings configured to receive a suitable fastener that is then received in apertures in the front support beams 122 of the equipment rack 80.

In one embodiment, each of the rear mounting brackets 136 may be similarly L-shaped with a first elongate flange 142 configured to be positionable adjacent an outer surface of a respective side wall 88, 90 of the shuffle box housing 82 and a second flange 144. The rear mounting brackets 136 are not configured to be fixedly coupled to the shuffle box housing 82. Instead, the rear mounting brackets 136 are configured to couple to the shuffle box housing 82 via a slidable connection. In this regard, the shuffle box housing 82 may include a slide post 146 extending from an outer surface of each of the side walls 88, 90. The first elongate flange 142 of each of the rear mounting brackets 136 may include a slide groove 148 that extends longitudinally within the first elongate flange 142. The slide groove 148 is open to a tip end 150 of the first elongate flange and is configured to receive the slide post 146 on the shuffle box housing 82. In one embodiment, the tip end 150 of the first elongate flange 142 may be directed outwardly to avoid hard contact with a rear edge of the shuffle box housing 82 and to guide the shuffle box 78 within the pair of rear mounting brackets 136 during installation of the shuffle box 78 within the equipment rack 80. The second flange 144 of each of the rear mounting brackets 136 may be similar to the second flange 140 of the front mounting brackets 134 and extend outwardly from the respective side wall 88, 90 of the shuffle box housing 82. The second flange 144 may include one or more openings configured to receive a suitable fastener that is then received in apertures in the rear support beams 124 of the equipment rack 80.

In one embodiment, to install the shuffle box 78 within the equipment rack 80, an installer first connects the rear mounting brackets 136 to the rear support beams 124 of the equipment rack 80 at the desired location within the equipment rack 80. Next, the installer couples the front mounting brackets 134 to the respective first and second side walls 88, 90 of the shuffle box housing 82. The installer then inserts the shuffle box 78 into the equipment rack 80 from a front side of the equipment rack 80, for example. As the installer moves the shuffle box 78 into the equipment rack 80, the slide posts 146 extending from the side walls 88, 90 of the shuffle box housing enter the slide grooves 148 in the rear mounting brackets 136 to thereby support the shuffle box 78 on the rear mounting brackets 136. With continued movement into the equipment rack 80, the second flanges 140 of the first mounting brackets 134 engage or nearly engage with the front support beams 122 of the equipment rack 80. Suitable fasteners may then be inserted through the front mounting brackets 134 and the front support beams 122 to support the shuffle box 78 within the equipment rack 80.

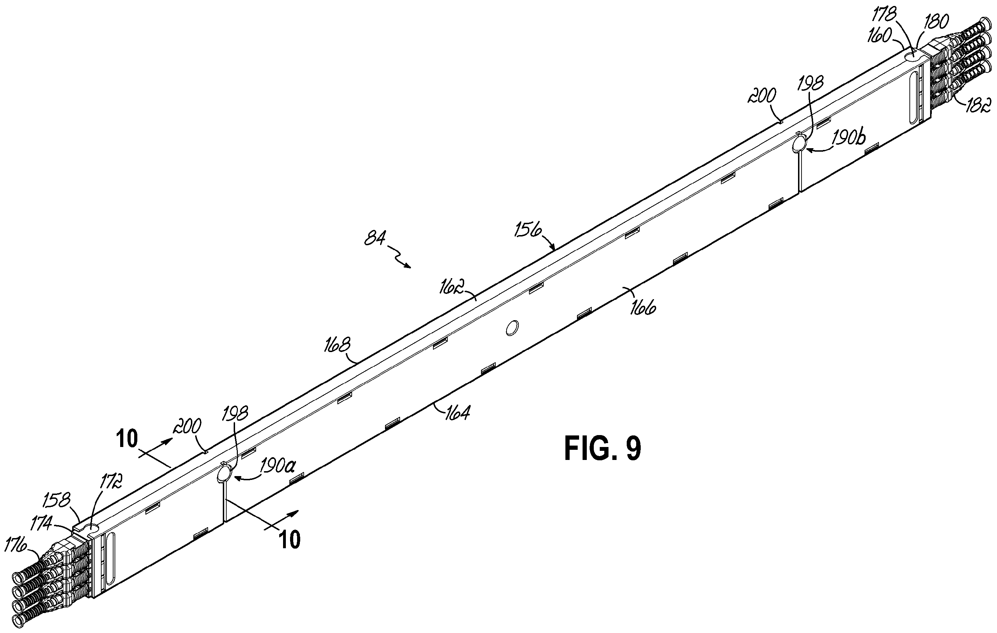

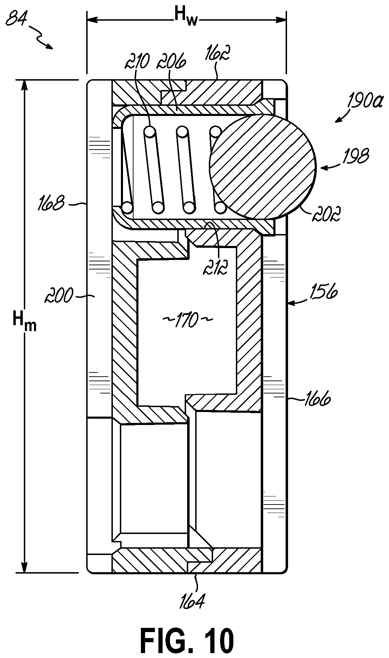

Figs. 9 and 10 illustrate an exemplary embodiment of a shuffle module 84 according to the disclosure. The shuffle module 84 includes a generally rectangular, elongate module housing 156 having a front end 158, a rear end 160, a top wall 162, a bottom wall 164, a first side wall 166 and a second side wall 168. In one embodiment, the module housing 156 defines an interior cavity 170 that is open at the front end 158 and the rear end 160. The front end 158 of the module housing 156 is closed off by a front optical interface 172 that defines a plurality of input connector ports 174. For example, the front optical interface 172 may include an adapter bank that defines the plurality of input connector ports 174. In one embodiment, the front optical interface 172 may be designed such that the plurality of input connector ports 174 is arranged in a single column configuration (n x 1 array). In this way, for example, the width Wₘ of the module housing 156 may be approximately the width of an input connector port 174.

In the illustrated embodiment, the front optical interface 172 may include four input connector ports 174 (i.e., n = 4). It should be recognized, however, that the number of input connector ports 174 in the front optical interface 172 may be more or less than this number depending on the particular application. The height Hₘ of the module housing 156 may be approximately the height of the column of input connector ports 174. While the front optical interface 172 is shown as a n x 1 array, it should be recognized that other configurations are also possible. For example, the front optical interface 172 may be configured as an n x 2 array as well. In an exemplary embodiment, the length Lₘ of the module housing 156 may be configured to be greater than, and preferably significantly greater than the height Hₘ and the width Wₘ of the module housing 156. In one embodiment, the input connector ports 174 of the front optical interface 172 may be configured to receive multi-fiber fiber optic connectors 176, such as MPO or MMC or other existing or later developed multi-fiber fiber optic connectors, from input fiber optic cables (not shown), such as from fiber optic cables 58. Embodiments are also possible involving other connector types, such as duplex connectors (e.g., LC, SN, or MDC connectors).

In a similar manner, the rear end 160 of the module housing 156 may be closed off by a rear optical interface 178 that defines a plurality of rear connector ports 180. For example, the rear optical interface 178 may include an adapter bank that defines the plurality of rear connector ports 180. In one embodiment, the rear optical interface 178 may be designed such that the plurality of rear connector ports 180 is arranged in a single column configuration (n x 1 array). While the rear optical interface 178 is shown as a n x 1 array, it should be recognized that other configurations are also possible. For example, the rear optical interface 178 may be configured as an n x 2 array as well. In one embodiment, the output connector ports 180 of the rear optical interface 178 may be configured to receive multi-fiber fiber optic connectors 182, such as MPO or MMC or other existing or later developed multi-fiber fiber optic connectors, from output fiber optic cables (not shown), such as from fiber optic cables 48. Embodiments are also possible involving other connector types, such as duplex connectors (e.g., LC, SN, or MDC connectors). In an exemplary embodiment, the number and arrangement of front connector ports 174 and the rear connector ports 180 may be the same. In an alternative embodiment, however, the front optical interface 172 and the rear optical interface 178 may be different from each other, e.g., either in number of connector ports or in port configuration.

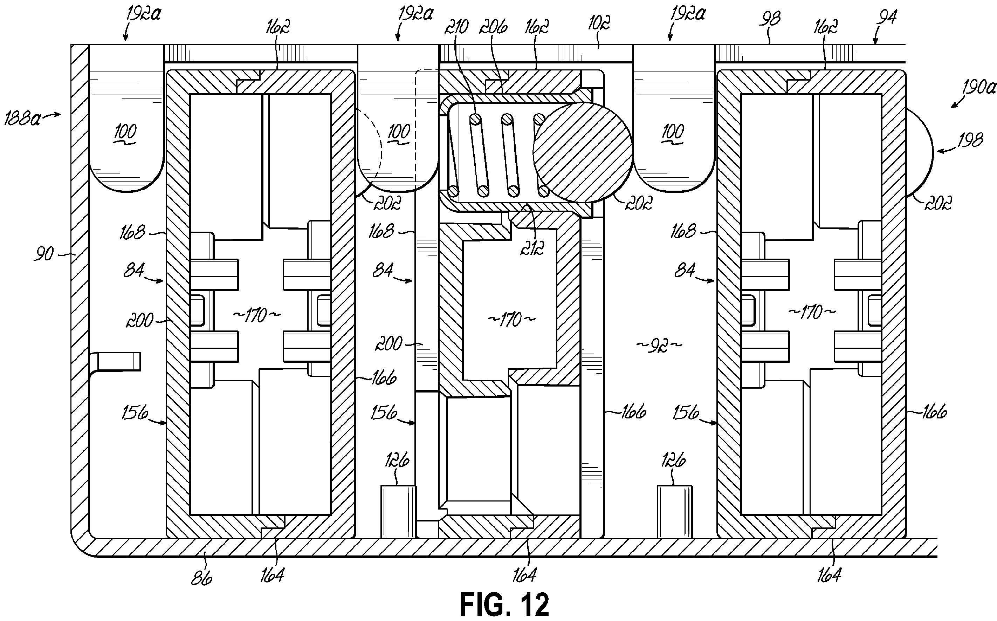

As was explained above, and as will be described in more detail below, each of the shuffle modules 84 may be configured to move relative to the shuffle box housing 82 between an operative position and an installation position. However, once a shuffle module 84 is in the operative position or the installation position it is useful to be able to secure or "lock" its position relative to the shuffle box housing 82 and prevent unintended movement of the shuffle modules 84. Thus, in one embodiment, the shuffle box 78 may include a plurality of locking mechanisms that lock each of the shuffle modules 84 in their installation position, and optionally in their operative position. For example, as illustrated in Figs. 9-12, the shuffle box 78 may include a plurality of front locking mechanisms 188a for locking the shuffle modules 84 in their installation positions. The shuffle box 78 may also include a plurality of rear locking mechanisms 188b for locking the shuffle modules 84 in their operative positions. The plurality of front locking mechanisms 188a and the plurality of second locking mechanisms 188b may be separate mechanisms having, for example, different locations in the shuffle box 78.

In one embodiment, each of the plurality of front locking mechanisms 188a may include a first locking arrangement/feature 190a associated with each of the plurality of shuffle modules 84 and a second locking arrangement/feature 192a associated with the shuffle box housing 82. For each shuffle module 84, the associated first locking arrangement 190a is configured to interact with a respective second locking arrangement 192a to lock the shuffle module 84 in its installation position. As will be described in more detail below, the second locking arrangement 192a associated with the shuffle box housing 82 may comprise one of the plurality of retention tabs 100 on the front guide rail 94. Thus, the plurality of retention tabs 100 on the front guide rail 94 may be configured to interact with the first locking arrangement 190a associated with a respective one of shuffle modules 84 to lock the shuffle modules 84 in their installation position.

In one embodiment, for each shuffle module 84, the associated first locking arrangement 190a may include a biasing member 198 on one side of the module housing 156 and a retention groove 200 on an opposite side of the module housing 156. The biasing member 198 may include a high-biased state and a low-biased state. In the high-biased state, the biasing member 198 may include a relatively high level of stored or potential energy. In the low-biased state, the biasing member 198 may include a relatively low level of stored or potential energy. Moreover, the biasing member 198 may include a projecting portion 202 extendable and retractable relative to one of the side walls 166, 168 of the module housing 156. For example, in the low-biased state of the biasing member 198, the projection portion 202 may extend outboard of the module housing 156 by a first distance, e.g., a first distance beyond the outer surface of the one of the side walls 166, 168 from which it extends. In the high-biased state of the biasing member 198, the projecting portion 202 may be retracted so as to extend outboard of the module housing 156 by a second distance that is less than the first distance, or so as to be inboard of the module housing 156, e.g., inside of the one of the side walls 166, 168 from which it extends. In other words, the projecting portion 202 is in an extended position in the low-biased state and in a retracted position when in the high-biased state.

Figs. 9 and 10 illustrate a biasing member 198 in accordance with one embodiment of the disclosure. In this regard, the biasing member 198 may be configured as a ball plunger 204. In one embodiment, the ball plunger 204 may include a casing 206, a ball 208 which operates as the projecting portion 202 moveable between the extended position and the retracted position, and a spring 210 positioned within the casing 206 and engaging the ball 208 to urge the ball toward the extended position. As is understood by those of ordinary skill, the spring 210 is configured to store energy when the ball 208 is moved from the extended position toward the retracted position. The ball plunger 204 may be received within a cavity 212 formed in one or both the side walls 166, 168 of the module housing 156 such that when the ball 208 is in its extended position, a portion of the ball 208 extends outboard of the surface of the side wall 166 or 168, and in its retracted position, the ball 208 extends outboard of the surface of the side wall 166 or 168 to a lesser extent or does not extend outboard at all. For example, the ball 208 may be positioned within the boundary of the module housing 156.

While the biasing member 198 is shown and described above as a ball plunger 204, aspects of the disclosure are not limited to such an embodiment. In an alternative embodiment, for example, the biasing member 198 may include an elastomeric projection extending from the one of the side walls 166, 168 of the module housing 156. In such an embodiment, the elastic nature of the material of the projection is what provides the energy storage, much like the spring 210 described above. For example, the biasing member 198 may comprise a rubber bump or nub extending from one of the side walls 166, 168 of the module housing 156. Thus, aspects of the disclosure should not be limited to the biasing member 198 having any particular configuration.

As noted above, the front locking arrangement 190a also includes a retention groove 200 on the other side wall 166, 168 from where the biasing member 198 is located. In one embodiment, the retention groove 200 may extend along a full height Hₘ of the module housing 156 so as to be open at the top wall 162 and the bottom wall 164 of the module housing 156. In an alternative embodiment, however, the retention groove 200 may only extend along a portion of the height Hₘ of the shuffle module 84 but be open along one of the top wall 162 or the bottom wall 164 of the module housing 156. The depth of the retention groove 200 may be relatively small compared to, for example, the width Wₘ of the of the shuffle module 84. For example, the depth of the retention groove 200 may be between about 5% and about 15% of the width Wₘ of the shuffle module 84. The dimension of the retention groove 200 in the longitudinal direction of the shuffle module 84 may be again relatively small. As will be made clear below, this dimension of the retention groove 200 may be generally based on a thickness of the retention tabs 100 on the front guide rail 94.

In one embodiment, the rear locking mechanisms 188b may each be configured similar to each of the first locking mechanisms 188a described above. Thus, each of the plurality of rear locking mechanisms 188b may include a first locking arrangement/feature 190b associated with each of the plurality of shuffle modules 84 and a second locking arrangement/feature 192b associated with the shuffle box housing 82. For each shuffle module 84, the associated first locking arrangement 190b is configured to interact with a respective second locking arrangement 192b to lock the shuffle module 84 in its operative position. As will be described in more detail below, the second locking arrangement 192b associated with the shuffle box housing 82 may comprise one of the plurality of retention tabs 106 on the rear guide rail 96. Thus, the plurality of retention tabs 106 on the rear guide rail 96 may be configured to interact with the first locking arrangement 190b associated with a respective one of shuffle modules 84 to lock the shuffle modules 84 in their operative position.

In one embodiment, for each shuffle module 84, the associated first locking arrangement 190b may include a biasing member 198 on one side of the module housing 156 and a retention groove 200 on an opposite side of the module housing 156. The biasing member 198 may include a high-biased state and a low-biased state. In the high-biased state, the biasing member 198 may include a relatively high level of stored or potential energy. In the low-biased state, the biasing member 198 may include a relatively low level of stored or potential energy. Moreover, the biasing member 198 may include a projecting portion 202 extendable and retractable relative to one of the side walls 166, 168 of the module housing 156. For example, in the low-biased state of the biasing member 198, the projection portion 202 may extend outboard of the module housing 156 by a first distance, e.g., a first distance beyond the outer surface of the one of the side walls 166, 168 from which it extends. In the high-biased state of the biasing member 198, projecting portion 202 may be retracted so as to extend outboard of the module housing 156 by a second distance that is less than the first distance, or so as to be inboard of the module housing 156, e.g., inside of the one of the side walls 166, 168 from which it extends. In other words, the projecting portion 202 is in an extended position in the low-biased state and in a retracted position when in the high-biased state.

With the shuffle box 78 described in detail above, use/operation of the shuffle box 78, such as by an installer during data center network installation, will now be described. The starting point for the operational description that follows includes the plurality of shuffle modules 84 being positioned in the mounting region 92 of the shuffle box housing 82 and all of the shuffle modules 84 being in their operational position. In one embodiment, the shuffle box 78 may already be mounted in the equipment rack 80 and may already have fiber optic connectors 182 connected to the output connector ports 180 of the shuffle modules 84. Thus, a remaining step is to connect fiber optic connectors 176 to the input connector ports 174 of the shuffle modules 84. Other operational starting points are also possible and remain within the scope of the present disclosure. Those of ordinary skill in the art will understand operation from those starting points based on the description below.

To this end, an installer may move one of the shuffle modules 84 from its operative position to its installation position. The shuffle modules 84 adjacent to the selected shuffle module 84 should be maintained in their operative position. In one embodiment, preferably each of the remaining shuffle modules 84 remain in their operative position. This separates and easily isolates the input connector ports 174 associated with the selected shuffle module 84 so that the installer may easily insert the fiber optic connectors 176 into respective input connector ports 174 without interference from a neighboring shuffle module 84 or its associated fiber optic connectors 176 (if already connected).

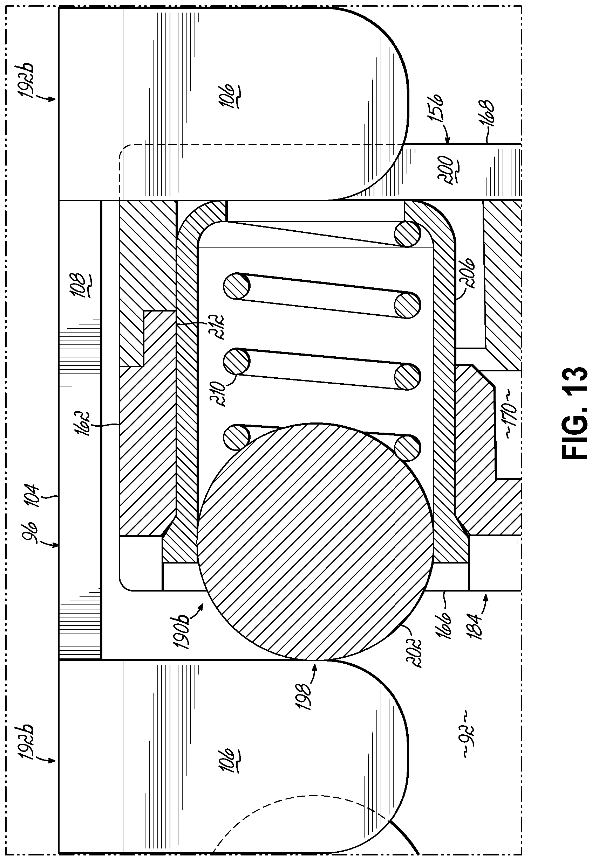

As noted above, the selected shuffle module 84 may be locked in its operative position by one of the rear locking mechanisms 188b. In this regard, and as illustrated in Fig. 13, the biasing mechanism 198 associated with the selected shuffle module 84 engages one of the retention tabs 106 on the rear guide rail 96 so as to urge the retention groove 200 on the selected shuffle module 84 (on the opposite side of the shuffle module 84) into contact or near contact with another of the plurality of retention tabs 106 on the rear guide rail 96, i.e., the another retention tab 106 is disposed within the retention groove 200 of the selected shuffle module 84. In this engaged position, the selected shuffle module 84 is "locked" in that a force imposed on the selected shuffle module 84 in the slide direction (e.g., the longitudinal direction) will urge the walls of the retention groove 200 into immediate contact with the retention tab 106 disposed therein to prevent sliding movement of the selected shuffle module 84 away from its operative position.

Thus, the rear locking mechanism 188b corresponding to the selected shuffle module 84 has to be disengaged prior to moving the selected shuffle module 84 from its operative position to its installation position. In one embodiment, disengaging the selected shuffle module 84 from its locked, operative position may be a two-step, two-force process. In a first step, a first force F₁ is imposed in a direction opposite to the biasing force created by the biasing member 198. In one embodiment, the biasing force from the biasing member 198, and thus the first force F₁ is in a direction different from the slide or movement direction of the selected shuffle module 84 from its operative position to its installation position. For example, in the illustrated embodiment, the direction of the first force F₁ and the slide or movement direction of the selected shuffle module 84 may be perpendicular to each other.

Imposing the first force F₁ on the selected shuffle module 84 urges the selected shuffle module 84 away from the (engaged) retention tab 106 such that the retention tab 106 is no longer disposed in the retention groove 200 of the selected shuffle module 84. As a result, the selected shuffle module 84 is no longer prevented from moving relative to the shuffle box housing 82 in a direction toward the installation position. Thus, a second force F₂ may then be imposed on the selected shuffle module 84 in the direction toward the installation position to move the selected shuffle module 84 toward the installation position. The distance between the operative position and the installation position may vary but may be between about 3 cm and about 12 cm, and preferably between about 5 cm and about 10 cm. The extension portion 110 of the shuffle housing 82 is configured to permit the length of travel desired in the particular application.

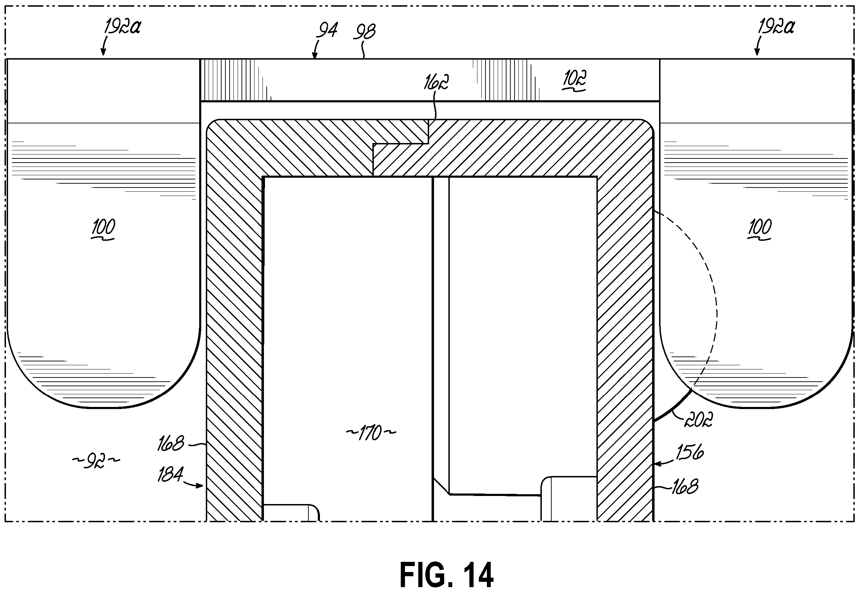

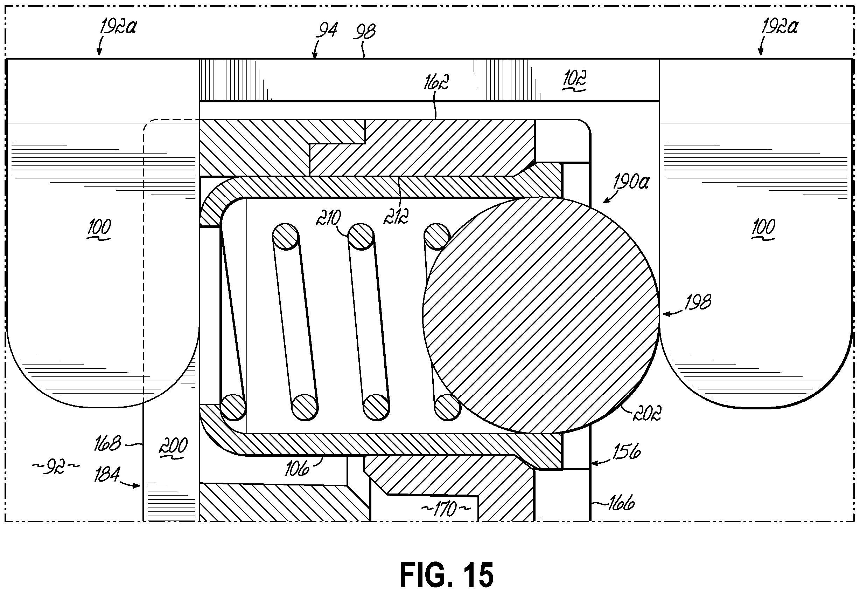

As noted above, the selected shuffle module 84 may be locked in its installation position by one of the front locking mechanisms 188a. Fig. 14 illustrates the arrangement between the front biasing mechanism 198 and the front retention tabs 100 as the selected shuffle module 84 approaches the installation position (from a perspective at the front of the shuffle box 78). As illustrated in Fig. 15, with further movement, the front biasing mechanism 198 associated with the selected shuffle module 84 engages one of the retention tabs 100 on the front guide rail 96 (right side of Fig. 15) so as to urge the front retention groove 200 on the selected shuffle module 84 (on the opposite side of the shuffle module 84) into contact or near contact with another one of retention tabs 100 on the front guide rail 94, i.e., the another retention tab 100 (left side of Fig. 15) is disposed within the front retention groove 200. In this engaged position, the selected shuffle module 84 is "locked" in that a force imposed on the selected shuffle module 84 in the slide direction (e.g., the longitudinal direction) will urge the walls of the front retention groove 200 into immediate contact with the retention tab 100 disposed therein to prevent sliding movement of the selected shuffle module 84 away from the installation position.

With the selected shuffle module 84 in its installation position, and its neighboring shuffle modules 84 in their operative position, the input connector ports 174 of the selected shuffle module 84 are isolated from those of its neighboring shuffle modules 84. In this position, an installer is able to more easily, and with less congestion and interference from the neighboring shuffle modules 84, connect at least one fiber optic connector 176, and preferably a plurality of fiber optic connectors 176, into a respective one of the input connector ports 174 of the selected shuffle module 84. In one beneficial aspect, the insertion direction of the fiber optic connectors 176 into their respective input connector ports 174 may be parallel to the movement or slide direction of the shuffle modules 84. Thus, the insertion force urges the walls of the front retention groove 200 into immediate contact with the retention tab 100 disposed therein to prevent sliding movement of the selected shuffle module 84 away from the installation position. The engagement of the front retention groove 200 with its associated front retention tab 100 is a hard stop that can withstand relatively large forces. Thus, even if the insertion force necessary to connect the fiber optic connectors 176 to their respective input connector ports 174 is relatively high, the selected shuffle module 84 is prevented from moving away from the installation position under that insertion force.

Once the desired number of fiber optic connectors 176 are connected to the selected shuffle module 84, the selected shuffle module 84 may be moved from its installation position back to its operative position. Thus, the front locking mechanism 188a corresponding to the selected shuffle module 84 has to be disengaged prior to moving the selected shuffle module 84 from its installation position to its operative position. In one embodiment, and similar to the above, disengaging the selected shuffle module 84 from its locked, installation position may be a two-step, two-force process. In a first step, a first force F₁ is imposed in a direction opposite to the biasing force created by the front biasing member 198. In one embodiment, the biasing force from the front biasing member 198, and thus the first force F₁ may be in a direction different from the slide or movement direction of the selected shuffle module 84 from the installation position to the operative position. For example, in the illustrated embodiment, the direction of the first force F₁ and the slide or movement direction of the selected shuffle module 84 may be perpendicular to each other.

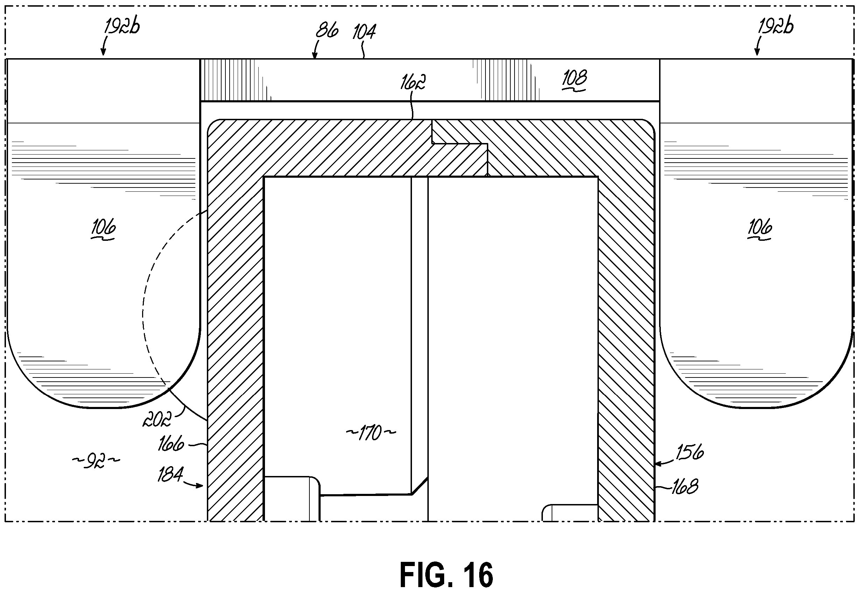

Imposing the first force F₁ on the selected shuffle module 84 urges the selected shuffle module 84 away from the (engaged) retention tab 100 such that the retention tab 100 is no longer disposed in the front retention groove 200 of the selected shuffle module 84. As a result, the selected shuffle module 84 is no longer prevented from moving relative to the shuffle box housing 82 in a direction toward the installation position. Thus, a second force F₂ may then be imposed on the selected shuffle module 84 in the direction toward the operative position to move the selected shuffle module 84 toward the operative position. Fig. 16 illustrates the arrangement between the rear biasing mechanism 198 and the rear retention tabs 106 as the selected shuffle module 84 approaches the installation position (from a perspective at the rear of the shuffle box 78). As illustrated in Fig. 13, with further movement, the rear biasing mechanism 198 associated with the selected shuffle module 84 engages one of the retention tabs 106 on the rear guide rail 96 (right side of Fig. 13) so as to urge the rear retention groove 200 on the selected shuffle module 84 (on the opposite side of the shuffle module 84) into contact or near contact with another of the plurality of retention tabs 106 on the rear guide rail 96, i.e., the another retention tab 106 (left side of Fig. 13) is disposed within the rear retention groove 200. In this engaged position, the selected shuffle module 84 is "locked" in that a force imposed on the selected shuffle module 84 in the slide direction (e.g., the longitudinal direction) will urge the walls of the rear retention groove 200 into immediate contact with the retention tab 106 disposed therein to prevent sliding movement of the selected shuffle module 84 away from the installation position.

As can be appreciated, the process described above may be repeated for each of the shuffle modules 84 in the shuffle box 78. Thus, for each of the shuffle modules 84 in the shuffle box 78, the input connector ports 174 on the shuffle modules 84 may be isolated from (i.e., moved out of the plane) the input connector ports 174 of the remaining shuffle modules 84. This clearly identifies the connector ports 174 to which fiber optic connectors 176 are to be connected, resulting in fewer misconnections. Additionally, with extra space in the immediate vicinity of the input connector ports 174, installers may more easily make the desired connections, which decreases installation time, for example.

While the benefits of a modular and moveable shuffle box 78 are described above for the connection of fiber optic connectors 176 in the input connector ports 174, such a design of the shuffle box 78 may also prove beneficial for the connection of fiber optic connectors 182 to the output connector ports 180. In this regard, to isolate the output connector ports 180 on a selected shuffle module 84, initially each of the plurality of shuffle modules 84 may be positioned in their installation position (using the terminology from above). Then, the selected shuffle module 84 may be moved from the installation position to the operative position. In this configuration, the output ports 180 of the selected shuffle module 84 are isolated from the output ports 180 of the remaining shuffle modules 84 in the shuffle box 78. Similar to the above, this allows installers to insert fiber optic connectors 182 into the output ports 180 of the selected shuffle module 84 easier and with fewer misconnections. Thus, aspects of the disclosure may prove beneficial when making optical connections at both the front optical interface 172 and the rear optical interface 178 of the shuffle box 78.

While the present disclosure has been illustrated by the description of specific embodiments thereof, and while the embodiments have been described in considerable detail, it is not intended to restrict or in any way limit the scope of the appended claims to such detail. The various features discussed herein may be used alone or in any combination within and between the various embodiments. Additional advantages and modifications will readily appear to those skilled in the art. The disclosure in its broader aspects is therefore not limited to the specific details, representative apparatus and methods and illustrative examples shown and described. Thus, it should be evident that departures may be made from such details without departing from the scope of the disclosure.

## Claims

1. An optical shuffle device for mounting in an equipment rack of a fiber optic network, comprising:
a shuffle housing configured to be mountable in the equipment rack, the shuffle housing including a base, a first side wall, a second side wall, and a first guide rail extending between the first and second side walls, wherein the base defines mounting region of the shuffle housing, and wherein the first guide rail comprises:
a beam spaced above the base; and
a plurality of retention tabs distributed along the beam and extending from the beam toward the base; and
a plurality of shuffle modules configured to be arranged in the mounting region of the shuffle housing and each comprising:
a module housing defining opposed first and second ends, opposed top and bottom walls, opposed first and second side walls, and an interior cavity;
a plurality of first connector ports at the first end of the module housing;
a first biasing member on the first side wall, wherein the first biasing member is moveable relative to the first side wall between an extended position and a retracted position; and
a first retention groove on the second side wall at a location opposite the first biasing member,
wherein when arranged in the mounting region of the shuffle housing:
each shuffle module of the plurality of shuffle modules is movable in a longitudinal direction between a first position and a second position,
when each shuffle module of the plurality of shuffle modules is in the first position, the first biasing member on the first side wall is configured to cooperate with one of the retention tabs to position the shuffle module to cause another of the retention tabs to be received in the first retention groove on the second side wall and thereby interfere with the shuffle module moving in the longitudinal direction.

2. The optical shuffle device of claim 1, wherein each of the plurality of shuffle modules defines a height (Hₘ) between the opposed top and bottom walls, and wherein the beam of the guide rail is spaced from the base by a distance that is between about 1 to about 1.15 times the height (Hₘ) of the plurality of shuffle modules.

3. The optical shuffle device of claim 1 or 2, wherein each of the plurality of shuffle modules defines a width (Wₘ) between the opposed first and second side walls, and wherein the plurality of first retention tabs is equally spaced along the beam of the first guide rail by a distance that is between about 1 to about 1.15 times the width (Wₘ) of the plurality of shuffle modules.

4. The optical shuffle device of any of the preceding claims, wherein for each of the plurality of shuffle modules the plurality of first connector ports is configured in an (n x 1) array, where n is the number of first connector ports.

5. The optical shuffle device of any of the preceding claims, wherein each of the plurality of shuffle modules further comprises:
at least one second connector port at the second end of the module housing; and
a plurality of optical fibers extending within the interior cavity between the plurality of first connector ports and the at least one second connector port in a predetermined pattern.

6. The optical shuffle device of claim 5, wherein for each of the plurality of shuffle modules the at least one second connector port comprises a plurality of second connector ports, and wherein the plurality of first connector ports and the plurality of second connector ports are each configured in an (n x 1) array, where n is the number of first and second connector ports, respectively.

7. The optical shuffle device of any of the preceding claims, wherein:
the first guide rail is positioned closer to a front of the base than to a rear of the base, and
for each shuffle module of the plurality of shuffle modules, the first position is an installation position and the second position is an operative position.

8. The optical shuffle device of claim 7, wherein when arranged in the mounting region of the shuffle housing, each shuffle module of the plurality of shuffle modules is positioned entirely over the base of the shuffle housing in both the installation position and the operative position.

9. The optical shuffle device of claim 7 or 8, wherein:
the at least one guide rail further comprises a second guide rail that is spaced from the first guide rail in the longitudinal direction,
the plurality of retention tabs on the first guide rail and the plurality of retention tabs on the second guide rail are aligned to define a plurality of module bays, and
wherein each of the plurality of module bays is configured to receive a respective shuffle module of the plurality of shuffle modules.

10. The optical shuffle device of claim 9, wherein each shuffle module of the plurality of shuffle modules further comprises:
a second biasing member on the first side wall, wherein the second biasing member is moveable relative to the first side wall between an extended position and a retracted position; and
a second retention groove on the second side wall at a location opposite the second biasing member,
wherein when the shuffle module is arranged in the mounting region of the shuffle housing and in the operative position, the second biasing member on the first side wall is configured to cooperate with one of the retention tabs on the second guide rail to cause another of the retention tabs on the second guide rail to be received in the second retention groove on the second side wall and thereby interfere with the shuffle module moving in the longitudinal direction.

11. The optical shuffle device of any of the preceding claims, wherein:
the first guide rail is positioned closer to a rear of the base than to a front of the base, and
for each shuffle module of the plurality of shuffle modules, the first position is an operative position and the second position is an installation position.

12. The optical shuffle device of any of the preceding claims, wherein the shuffle housing further comprises:
a plurality of guide pegs extending from the base,
wherein the plurality of guide pegs is arranged in at least one row transverse to the longitudinal direction, and preferably at least two rows, and
wherein the plurality of retention tabs on the first guide rail and the plurality of guide pegs are aligned in the longitudinal direction.

13. The optical shuffle device of any of the preceding claims, further comprising:
a front pair of mounting brackets connected to the shuffle housing; and
a rear pair of mounting brackets slidably coupled to the shuffle housing,
wherein the front pair of mounting brackets and the rear pair of mounting brackets are configured to support the optical shuffle device within the equipment rack.

14. The optical shuffle device of any of the preceding claims, wherein for each shuffle module of the plurality of shuffle modules the first biasing member comprises a ball plunger, the ball plunger comprising:
a casing having an interior cavity;
a spring disposed in the interior cavity; and
a ball at least partially received in the interior cavity, the spring engaging the ball to bias the ball toward the extended position.

15. A method of using the optical shuffle device of any of the preceding claims, comprising:
moving a selected shuffle module of the plurality of shuffle modules from the second position to the first position, wherein after the moving the first biasing member on the first side wall of the selected shuffle module is in the extended position and cooperates with one of the retention tabs on the first guide rail to bias the first retention groove on the second side wall toward another one of the retention tabs on the first guide rail such that the another one of the retention tabs is received in the first retention groove and interferes with the shuffle module moving to the second position;
moving the first biasing member to the retracted position so that the selected shuffle module has a position in which the another one of the retention tabs is not received in the first retention groove; and
moving selected shuffle module to the second position.
